# EUROPÄISCHE PATENTANMELDUNG

(11) **EP 3 863 386 A1**
(43) Veröffentlichungstag der Anmeldung: **11.08.2021**
(21) Anmeldenummer: 21151051.6
(22) Anmeldetag: 12.01.2021
(51) Int. Cl.: H05K 1/14

(54) **LEITERPLATTENANORDNUNG UND VERFAHREN ZUM HERSTELLEN EINER LEITERPLATTENANORDNUNG**

(30) Priorität: 05.02.2020 DE 102020102941
(71) Anmelder: Marelli Automotive Lighting Reutlingen (Germany) GmbH, 72762 Reutlingen (DE)
(72) Erfinder: Schöning, Michael, 37154 Northeim (DE)
(74) Vertreter: DREISS Patentanwälte PartG mbB

(57) **Zusammenfassung**

Leiterplattenanordnung (10), umfassend ein Trägerelement (12), eine auf dem Trägerelement (12) angeordnete Leiterplatte (14), wobei die Leiterplatte (14) eine Öffnung (16) aufweist, und einen in der Öffnung (16) der Leiterplatte (14) angeordneten Einsatz (18), wobei eine erste Oberfläche (22) des Einsatzes (18) gegenüber einer ersten Oberfläche (36) der Leiterplatte (14) zurückversetzt angeordnet ist, und in und/oder an dem freiem Randbereich (40) wenigstens ein Haltemittel (42) ausgebildet ist und der Einsatz (18) mittels des Haltemittels (42) und der Leiterplatte (14) in der Öffnung (16) und auf dem Trägerelement (12) gehalten wird.

## Beschreibung

Die Erfindung betrifft eine Leiterplattenanordnung gemäß dem Oberbegriff des Anspruchs 1.

Ferner betrifft die Erfindung ein Verfahren zum Herstellen einer Leiterplattenanordnung gemäß dem Oberbegriff des Anspruchs 11.

Aus dem Stand der Technik sind Leiterplattenanordnungen mit einer Leiterplatte, die auf einer, insbesondere metallischen Trägerplatte, angeordnet ist, bekannt. Die Trägerplatte dient beispielsweise als Kühlkörper. Ferner ist es bekannt, in der Leiterplatte einen sogenannten Einsatz, engl. Inlay, vorzusehen. Ein solcher Einsatz dient beispielsweise zur Wärmeableitung, insbesondere von thermisch kritischen Bereichen der Leiterplatte. Die Leiterplatte umfasst beispielsweise einen Faserverbundwerkstoff, insbesondere FR4.

Aufgabe der vorliegenden Erfindung ist es, eine gegenüber dem Stand der Technik verbesserte Leiterplattenanordnung anzugeben.

Erfindungsgemäß ist vorgesehen, dass der Einsatz derart in der Öffnung angeordnet ist, dass eine auf einer von dem Trägerelement abgewandten ersten Seite des Einsatzes, angeordnete erste Oberfläche des Einsatzes und eine auf einer von dem Trägerelement abgewandten ersten Seite der Leiterplatte, angeordnete erste Oberfläche der Leiterplatte flächenversetzt zueinander angeordnet sind, wobei die erste Oberfläche des Einsatzes gegenüber der ersten Oberfläche der Leiterplatte zurückversetzt angeordnet ist, so dass in einer die Öffnung der Leiterplatte begrenzenden Randfläche ein freier Randbereich ausgebildet ist, wobei in und/oder an dem freiem Randbereich wenigstens ein Haltemittel ausgebildet ist und der Einsatz mittels des Haltemittels und der Leiterplatte in der Öffnung und auf dem Trägerelement gehalten wird.

Als Materialien für solche Einsätze werden beispielsweise Metalle verwendet. Gemäß einer Ausführungsform erweist es sich als vorteilhaft, dass der Einsatz einen Grundkörper aus einem Keramikmaterial umfasst. Das Keramikmaterial ist beispielweise Aluminiumnitrid (AlN)-Keramik oder Aluminiumoxid (Al2O3)-Keramik. Die Wärmeleitfähigkeit des Keramikmaterials ist vorteilhafterweise größer als die Wärmeleitfähigkeit der Leiterplatte.

Gemäß einer Ausführungsform erweist es sich als vorteilhaft, dass die erste Oberfläche des Einsatzes eine, insbesondere strukturierte, Metallschicht umfasst. Diese Metallschicht ermöglicht eine effiziente thermisch und/oder elektrisch leitfähige Anbindung an ein oder mehrere weitere Komponenten.

Das Haltemittel zum Halten des Einsatzes in der Öffnung und auf dem Trägerelement kann beispielsweise als stoffschlüssige und/oder kraftschlüssige und/oder formschlüssige Verbindung ausgebildet sein.

Gemäß einer Ausführungsform erweist es sich als vorteilhaft, dass das Haltemittel eine Lötverbindung umfasst. In diesem Zusammenhang erweist es sich als vorteilhaft, wenn die Leiterplatte, insbesondere im Bereich der Randfläche der Öffnung, insbesondere im freien Randbereich und/oder der Einsatz geeignete Anschlussflächen umfassen. Eine Lötverbindung stellt vorteilhafterweise gleichzeitig eine mechanische und eine elektrische Verbindung zwischen der Leiterplatte und dem Einsatz bereit.

In Weiterbildung dieses Erfindungsgedankens erweist es sich als vorteilhaft, dass die Lötverbindung einen Lötmeniskus, umfasst, wobei der Lötmeniskus zwischen der Leiterplatte, insbesondere dem freien Randbereich der Leiterplatte, und dem Einsatz, insbesondere der ersten Oberfläche des Einsatzes, insbesondere der Metallschicht der Oberfläche, ausgebildet ist. Ein Lötmeniskus bezeichnet eine konkave Ausbildung der Lötverbindung, die durch Ausbildung flacher, durch eine tangentiale Kurve verbundener, Benetzungswinkel an benetzbaren Flächen entsteht.

Weiter kann es sich als vorteilhaft erweisen, dass das Haltemittel einen ausgehend von der Randfläche, insbesondere von dem freien Randbereich, in die Öffnung hineinragenden Vorsprung umfasst. Der Vorsprung kann auch umlaufend um die Öffnung ausgebildet sein. Dies erhöht vorteilhafterweise die Stabilität der Halterung des Einsatzes in der Öffnung und auf dem Trägerelement.

Weiter kann sich als vorteilhaft erweisen, wenn an der Randfläche, insbesondere an dem freien Randbereich, und/oder an dem in die Öffnung hineinragenden Vorsprung wenigstens ein elektrischer Anschlussbereich zum elektrischen Verbinden der Leiterplatte mit dem Einsatz, insbesondere mit der Oberfläche des Einsatzes, insbesondere mit der Metallschicht der Oberfläche, vorgesehen ist.

Gemäß einer Ausführungsform erweist sich als vorteilhaft, dass der elektrische Anschlussbereich eine beschichtete Durchkontaktierung, insbesondere eine halboffene und/oder halbrunde, beschichtete Durchkontaktierung umfasst. Diese Art von Durchkontaktierung ist auch unter der Bezeichnung Kantengalvanik bekannt. Details zur Kantengalvanik sind in der DE 10 2014 225 077 A1 der Anmelderin beschrieben.

Gemäß einer Ausführungsform ist vorgesehen, dass das Trägerelement ein Kühlkörper ist.

Gemäß einer Ausführungsform erweist es sich als vorteilhaft, dass das Trägerelement wenigstens einen Kontaktbereich für den Einsatz und wenigstens einen Kontaktbereich für die Leiterplatte umfasst, wobei der Kontaktbereich für den Einsatz als ein gegenüber dem Kontaktbereich für die Leiterplatte erhöhter Bereich ausgebildet ist. Die auf dem Trägerelement angeordnete Leiterplatte kontaktiert das Trägerelement in dem Kontaktbereich für die Leiterplatte und der Einsatz kontaktiert das Trägerelement im Bereich der Kontaktflächen für den Einsatz. Der Einsatz und die Leiterplatte können auf der dem Trägerelement zugewandten Seite flächenbündig oder flächenversetzt angeordnet sein.

Weiter kann es sich als vorteilhaft erweisen, wenn Befestigungsmittel zum Befestigen der Leiterplatte an dem Trägerelement vorgesehen sind. Beispielsweise kann das Befestigen der Leiterplatte auf dem Trägerelement mittels einer Klebeverbindung und/oder mittels einer mechanischen Befestigung, beispielsweise einer Niet- oder Schraubverbindung, erfolgen. Durch Vorsehen einer mechanischen Verbindung kann über die Leiterplatte zusätzlich eine auf den Einsatz einwirkende Kraft übertragen werden, wobei der Einsatz dadurch gegen das Trägerelement, insbesondere auf die Kontaktfläche des Trägerelements, gedrückt wird.

Weitere bevorzugte Ausführungsformen beziehen sich auf ein Verfahren zum Herstellen einer Leiterplattenanordnung gemäß den Ausführungsformen, wobei das Verfahren die folgenden Schritte umfasst:
Bereitstellen eines Trägerelements und einer auf dem Trägerelement angeordneten Leiterplatte, wobei die Leiterplatte eine Öffnung aufweist, Einbringen eines Einsatzes in die Öffnung der Leiterplatte, dadurch gekennzeichnet, dass der Einsatz derart in der Öffnung eingebracht wird, dass eine auf einer von dem Trägerelement abgewandten ersten Seite des Einsatzes, angeordnete erste Oberfläche des Einsatzes und eine auf einer von dem Trägerelement abgewandten ersten Seite der Leiterplatte, angeordnete erste Oberfläche der Leiterplatte flächenversetzt zueinander angeordnet sind, wobei die erste Oberfläche des Einsatzes gegenüber der ersten Oberfläche der Leiterplatte zurückversetzt angeordnet ist, so dass in einer Öffnung der Leiterplatte begrenzenden Randfläche ein freier Randbereich ausgebildet wird.

Vorteilhafterweise umfasst das Verfahren weiter das Herstellen wenigstens einer elektrisch leitenden Verbindung, insbesondere einer Lötverbindung, zwischen der Leiterplatte, insbesondere dem freien Randbereich der Leiterplatte, und dem Einsatz, insbesondere der ersten Oberfläche des Einsatzes, insbesondere der Metallschicht der Oberfläche.

Es kann sich als vorteilhaft erweisen, wenn das Einbringen des Einsatzes in die Öffnung der Leiterplatte durch Einpressen und/oder Eindrücken und/oder Einfügen und/oder Einrütteln erfolgt.

Es kann sich als vorteilhaft erweisen, wenn das Herstellen der Lötverbindung mittels Laserlöten erfolgt.

Weiter kann es sich als vorteilhaft erweisen, wenn das Verfahren weiter umfasst: Befestigen der Leiterplatte an dem Trägerelement. Beispielsweise kann das Befestigen der Leiterplatte auf dem Trägerelement mittels einer Klebeverbindung und/oder mittels einer mechanischen Befestigung, beispielsweise einer Niet- oder Schraubverbindung, erfolgen.

Ausführungsbeispiele der Erfindung sind in den Zeichnungen dargestellt und werden in der nachfolgenden Beschreibung näher erläutert. Dabei bezeichnen gleiche Bezugszeichen in verschiedenen Figuren jeweils gleiche oder zumindest ihrer Funktion nach vergleichbare Elemente. Es zeigen, jeweils in schematischer Form:
- Fig. 1: eine erfindungsgemäße Leiterplattenanordnung in einer Draufsicht gemäß einer ersten bevorzugten Ausführungsform;
- Fig. 2: die Leiterplattenanordnung aus Fig. 1 in einer Schnittansicht, und
- Fig. 3: eine erfindungsgemäße Leiterplattenanordnung in einer Schnittansicht gemäß einer weiteren bevorzugten Ausführungsform.

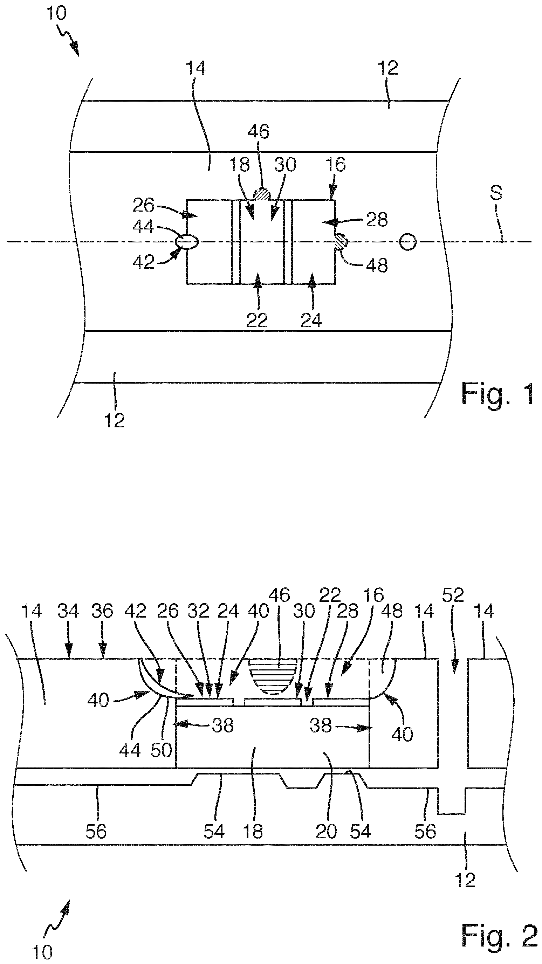

Figuren 1 und 2 zeigen eine Leiterplattenanordnung gemäß einer ersten Ausführungsform, wobei Figur 2 eine Schnittansicht durch die Schnittachse S der Figur 1 darstellt. Die Leiterplattenanordnung ist in ihrer Gesamtheit mit dem Bezugszeichen 10 bezeichnet.

Die Leiterplattenanordnung 10 umfasst ein Trägerelement 12 und eine auf einem Trägerelement 12 angeordnete Leiterplatte 14.

Bei dem Trägerelement 12 handelt es sich beispielsweise um einen Kühlkörper. Die Leiterplatte 14 umfasst beispielsweise einen Faserverbundwerkstoff, insbesondere FR4.

Die Leiterplatte 12 umfasst eine, insbesondere fensterartige Öffnung 16. In der Öffnung 16 der Leiterplatte 12 ist ein Einsatz 18 angeordnet.

Der Einsatz 18 umfasst beispielsweise einen Grundkörper 20 aus einem Keramikmaterial. Das Keramikmaterial ist beispielweise Aluminiumnitrid (AlN)-Keramik oder Aluminiumoxid (Al2O3)-Keramik. Die Wärmeleitfähigkeit des Keramikmaterials ist vorteilhafterweise größer als die Wärmeleitfähigkeit des Materials der Leiterplatte 14.

Eine erste Oberfläche 22 des Einsatzes 18, insbesondere die erste Oberfläche 22 des Grundkörpers 20, umfasst eine, insbesondere strukturierte, Metallschicht 24. Die Metallschicht 24 ermöglicht eine effiziente thermisch und/oder elektrisch leitfähige Anbindung an ein oder mehrere weitere Komponenten. Die Metallschicht 24 umfasst gemäß der dargestellten Ausführungsform beispielhaft Anschlussflächen für eine LED, insbesondere eine erste Anschlussfläche 26 für eine Anode, eine zweite Anschlussfläche 28 für eine Kathode und eine dritte Anschlussfläche 30 zum Verbinden mit einem Kühlkörper.

Die erste Oberfläche 22 des Einsatzes 20 ist auf einer von dem Trägerelement 12 abgewandten ersten Seite 32 des Einsatzes 20 angeordnet. Die Leiterplatte 14 umfasst auf einer auf einer von dem Trägerelement 12 abgewandten ersten Seite 34 eine erste Oberfläche 36. Die Oberfläche 36 der Leiterplatte 14 und die Oberfläche 22 des Einsatzes sind flächenversetzt zueinander angeordnet. Die erste Oberfläche 22 des Einsatzes 18 ist dabei gegenüber der ersten Oberfläche 36 der Leiterplatte 14 zurückversetzt angeordnet.

Die Öffnung 16 der Leiterplatte 14 ist durch eine Randfläche 38 begrenzt. Durch die zueinander flächenversetzten Oberflächen 22, 36 ist in der Randfläche 38 ein freier Randbereich 40 ausgebildet. An dem freien Randbereich 40 ist ein Haltemittel 42 ausgebildet. Gemäß der dargestellten Ausführungsform ist das Haltemittel 42 eine Lötverbindung 44. In dargestellten Ausführungsform ist beispielhaft nur ein Haltemittel 42 dargestellt. Vorteilhafterweise sind weitere Haltemittel 42 vorgesehen.

Gemäß der dargestellten Ausführungsform ist die Lötverbindung 44 in Form eines Lötmeniskus ausgebildet. Der Lötmeniskus ist zwischen der Leiterplatte 14, insbesondere dem freien Randbereich 40 der Leiterplatte 14, und dem Einsatz 18, insbesondere der ersten Oberfläche 22 des Einsatzes, insbesondere der Metallschicht 24 der Oberfläche 22, ausgebildet ist.

Gemäß der dargestellten Ausführungsform sind an der 38 Randfläche, insbesondere an dem freien Randbereich 40, elektrische Anschlussbereiche 46, 48, 50 zum elektrischen und mechanischen Verbinden der Leiterplatte 14 mit dem Einsatz 18, insbesondere mit der Oberfläche 22 des Einsatzes 18, insbesondere mit der Metallschicht 24 der Oberfläche 18, vorgesehen ist.

Die elektrische Anschlussbereiche 46, 48, 50 sind gemäß der dargestellten Ausführungsform als eine beschichtete Durchkontaktierung, insbesondere eine halboffene und/oder halbrunde beschichtete Durchkontaktierung ausgebildet. Diese Art von Durchkontaktierung ist auch unter der Bezeichnung Kantengalvanik bekannt. Details zur Kantengalvanik sind in der DE 10 2014 225 077 A1 der Anmelderin beschrieben.

Gemäß der dargestellten Ausführungsform ist das Haltemittel 42 als Lötverbindung 44 im Anschlussbereich 50 ausgebildet. Das Haltemittel bildet gemäß der dargestellten Ausführungsform sowohl eine elektrische als auch eine mechanische Verbindung zwischen der Leiterplatte 14 und dem Einsatz 18 aus. Der Einsatz 18 wird durch das Haltemittel 42 an der Leiterplatte 14 in der Öffnung 16 und auf dem Trägerelement 12 gehalten.

Gemäß der dargestellten Ausführungsform umfasst die Leiterplatte 14 eine Durchgangsbohrung 52. In der Durchgangsbohrung 52 kann eine Schraube zum Befestigen der Leiterplatte 14 auf dem Trägerelement 12 angeordnet werden. Vorteilhafterweise kann so eine Kraft, mit der der Einsatz 18 gegen das Trägerelement 12 gedrückt wird vergrößert werden.

Weiter umfasst das Trägerelement 12 Kontaktbereiche 54 für den Einsatz und Kontaktbereiche 56 für die Leiterplatte 14. Gemäß der dargestellten Ausführungsform sind die Kontaktbereiche 54 für den Einsatz 18 als gegenüber den Kontaktbereichen 56 für die Leiterplatte 14 erhöhte Bereiche ausgebildet. Beim Verschrauben der Leiterplatte 14 wird der Einsatz 18 vorteilhaft gegen die erhöhten Kontaktbereiche 54 gedrückt. Vorteilhafterweise kann auf dem Trägerelement 12 wenigstens ein weiterer definierter Anschlag (in der Figur nicht dargestellt) für die Leiterplatte 14 vorgesehen sein. Dieser Anschlag kann beispielsweise etwas niedriger als die erhöhten Kontaktbereiche 54 sein.

Gemäß einer weiteren möglichen Ausführungsform ist das Trägerelement 12 bevorzugt aus Aluminium mit erhöhten Kontaktbereichen und teileloxierten Bereichen ausgebildet. Die teileloxierten Bereiche besitzen aufgrund der Oberflächenstruktur des Eloxal eine elektrisch und thermisch isolierende Oberfläche. Im Fall von durchkontaktierten Bereichen der Leiterplatte 14 kann so beim Zusammenbau kein elektrischer Kurzschluss durch das Trägerelement 12 entstehen.

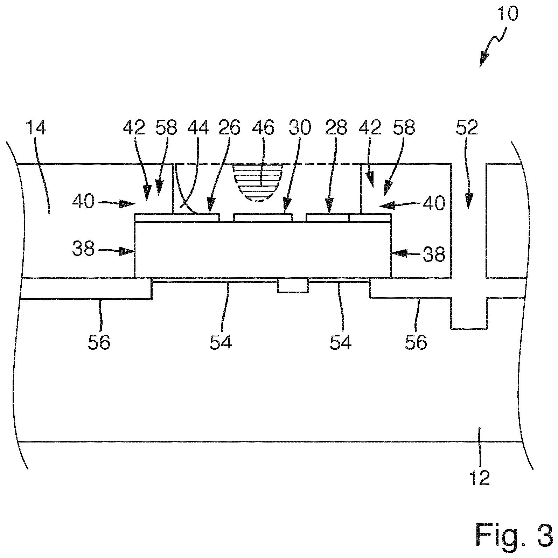

Figur 3 zeigt eine Leiterplattenanordnung 10 gemäß einer weiteren Ausführungsform. Elemente, mit gleichen Bezugszeichen wie in den Figuren 1 und 2, sind gleiche oder zumindest ihrer Funktion nach vergleichbare Elemente, und werden daher nicht nochmal in Bezug auf Figur 3 erläutert.

Gemäß der in Figur 3 dargestellten Ausführungsform ist das Haltemittel 42 als ein Vorsprung 58 ausgebildet. Der Vorsprung 58 ragt ausgehend von der Randfläche 38, insbesondere von dem freien Randbereich 40, in die Öffnung 16 hinein. Der Vorsprung 58 überragt den Einsatz 18. Der Vorsprung 58 kann auch umlaufend um die Öffnung 16 ausgebildet sein. Dies erhöht vorteilhafterweise die Stabilität der Halterung des Einsatzes 18 in der Öffnung 16 und auf dem Trägerelement 12.

## Patentansprüche

1. Leiterplattenanordnung (10), umfassend ein Trägerelement (12), eine auf dem Trägerelement (12) angeordnete Leiterplatte (14), wobei die Leiterplatte (14) eine Öffnung (16) aufweist, und einen in der Öffnung (16) der Leiterplatte (14) angeordneten Einsatz (18), **dadurch gekennzeichnet, dass** der Einsatz (18) derart in der Öffnung (16) angeordnet ist, dass eine auf einer von dem Trägerelement (12) abgewandten ersten Seite (32) des Einsatzes (18), angeordnete erste Oberfläche (22) des Einsatzes (18) und eine auf einer von dem Trägerelement (12) abgewandten ersten Seite (34) der Leiterplatte (14), angeordnete erste Oberfläche (36) der Leiterplatte (12) flächenversetzt zueinander angeordnet sind, wobei die erste Oberfläche (22) des Einsatzes (18) gegenüber der ersten Oberfläche (36) der Leiterplatte (14) zurückversetzt angeordnet ist, so dass in einer Öffnung (16) der Leiterplatte (14) begrenzenden Randfläche (38) ein freier Randbereich (40) ausgebildet ist, wobei in und/oder an dem freiem Randbereich (40) wenigstens ein Haltemittel (42) ausgebildet ist und der Einsatz (18) mittels des Haltemittels (42) und der Leiterplatte (14) in der Öffnung (16) und auf dem Trägerelement (12) gehalten wird.

2. Leiterplattenanordnung (10) nach Anspruch 1, **dadurch gekennzeichnet, dass** der Einsatz (18) einen Grundkörper (20) aus einem Keramikmaterial umfasst und/oder die erste Oberfläche (22) des Einsatzes (18) eine, insbesondere strukturierte, Metallschicht (24) umfasst.

3. Leiterplattenanordnung (10) nach einem der Ansprüche 1 oder 2, **dadurch gekennzeichnet, dass** das Haltemittel (42) eine Lötverbindung (44) umfasst.

4. Leiterplattenanordnung (10) nach Anspruch 3, **dadurch gekennzeichnet, dass** die Lötverbindung (44) einen Lötmeniskus, umfasst, wobei der Lötmeniskus zwischen der Leiterplatte (14), insbesondere dem freien Randbereich (40) der Leiterplatte (14), und dem Einsatz (18), insbesondere der ersten Oberfläche (22) des Einsatzes (18), insbesondere der Metallschicht (24) der Oberfläche (22), ausgebildet ist.

5. Leiterplattenanordnung (10) nach wenigstens einem der vorhergehenden Ansprüche, **dadurch gekennzeichnet, dass** das Haltemittel (42) einen ausgehend von der Randfläche (38), insbesondere von dem freien Randbereich (40), in die Öffnung (16) hineinragenden Vorsprung (58) umfasst.

6. Leiterplattenanordnung (10) nach wenigstens einem der vorhergehenden Ansprüche, **dadurch gekennzeichnet, dass** an der Randfläche (38), insbesondere an dem freien Randbereich (40), und/oder an dem Vorsprung (58) wenigstens ein elektrischer Anschlussbereich (46, 48, 50) zum elektrischen Verbinden der Leiterplatte (14) mit dem Einsatz (18), insbesondere mit der Oberfläche (22) des Einsatzes (18), insbesondere mit der Metallschicht (24) der Oberfläche (22), vorgesehen ist.

7. Leiterplattenanordnung (10) nach Anspruch 6, **dadurch gekennzeichnet, dass** der elektrische Anschlussbereich (46, 48, 50) eine beschichtete Durchkontaktierung, insbesondere eine halboffene und/oder halbrunde beschichtete Durchkontaktierung umfasst.

8. Leiterplattenanordnung (10) nach wenigstens einem der vorhergehenden Ansprüche, **dadurch gekennzeichnet, dass** das Trägerelement (12) ein Kühlkörper ist.

9. Leiterplattenanordnung (10) nach wenigstens einem der vorhergehenden Ansprüche, **dadurch gekennzeichnet, dass** das Trägerelement (12) wenigstens einen Kontaktbereich (54) für den Einsatz (18) und wenigstens einen Kontaktbereich (56) für die Leiterplatte (14) umfasst, wobei der Kontaktbereich (54) für den Einsatz (18) als ein gegenüber dem Kontaktbereich (56) für die Leiterplatte (14) erhöhter Bereich ausgebildet ist.

10. Leiterplattenanordnung (10) nach wenigstens einem der vorhergehenden Ansprüche, **dadurch gekennzeichnet, dass** Befestigungsmittel zum Befestigen der Leiterplatte (14) an dem Trägerelement (12) vorgesehen sind.

11. Verfahren zum Herstellen einer Leiterplattenanordnung (10) nach wenigstens einem der Ansprüche 1 bis 10; das Verfahren umfassend die folgenden Schritte:
Bereitstellen eines Trägerelements (12) und einer auf dem Trägerelement (12) angeordneten Leiterplatte (14), wobei die Leiterplatte (14) eine Öffnung (16) aufweist, Einbringen eines Einsatzes (18) in die Öffnung (16) der Leiterplatte (14), **dadurch gekennzeichnet, dass** der Einsatz (18) derart in der Öffnung (16) eingebracht wird, dass eine auf einer von dem Trägerelement (12) abgewandten ersten Seite (32) des Einsatzes (18), angeordnete erste Oberfläche (22) des Einsatzes (18) und eine auf einer von dem Trägerelement (12) abgewandten ersten Seite (34) der Leiterplatte (14), angeordnete erste Oberfläche (36) der Leiterplatte (14) flächenversetzt zueinander angeordnet sind, wobei die erste Oberfläche (22) des Einsatzes (18) gegenüber der ersten Oberfläche (36) der Leiterplatte (14) zurückversetzt angeordnet ist, so dass in einer die Öffnung (16) der Leiterplatte (14) begrenzenden Randfläche (38) ein freier Randbereich (40) ausgebildet wird.

12. Herstellen wenigstens einer elektrisch leitenden Verbindung, insbesondere einer Lötverbindung (44), zwischen der Leiterplatte (14), insbesondere dem freien Randbereich (38) der Leiterplatte (14), und dem Einsatz (18), insbesondere der ersten Oberfläche (22) des Einsatzes (18), insbesondere der Metallschicht (24) der Oberfläche (22).

13. Verfahren nach Anspruch 12, **dadurch gekennzeichnet, dass** das Einbringen des Einsatzes (18) in die Öffnung (16) der Leiterplatte (14) durch Einpressen und/oder Eindrücken und/oder Einfügen und/oder Einrütteln erfolgt.

14. Verfahren nach wenigstens einem der Ansprüche 11 oder 13, **dadurch gekennzeichnet, dass** das Herstellen der Lötverbindung (44) mittels Laserlöten erfolgt.

15. Verfahren nach wenigstens einem der Ansprüche 11 bis 14, **dadurch gekennzeichnet, dass** das Verfahren weiter umfasst: Befestigen der Leiterplatte (14) an dem Trägerelement (12).
